(19) Europäisches Patentamt
European Patent Office
Office européen des brevets

(11) Publication number: 0 325 342 B1

(12) # EUROPEAN PATENT SPECIFICATION

(45) Date of publication of patent specification: **15.12.93**

(51) Int. Cl.$^5$: **H01L 21/82**, H01L 21/265

(21) Application number: **89300019.0**

(22) Date of filing: **04.01.89**

(54) **Complementary BICMOS process with isolated vertical PNP transistors.**

(30) Priority: **21.01.88 US 146934**

(43) Date of publication of application:
**26.07.89 Bulletin 89/30**

(45) Publication of the grant of the patent:
**15.12.93 Bulletin 93/50**

(84) Designated Contracting States:
**AT DE FR GB IT NL**

(56) References cited:
**EP-A- 0 226 892**
**EP-A- 0 227 970**
**US-A- 4 637 125**

**IEEE ELECTRON DEVICES, vol. ED-27, no. 8, August 1980, pages 1394-1396, IEEE, New York, US; I.E. MAGDO: "Vertical p-n-p for complementary bipolar technology"**

(73) Proprietor: **EXAR CORPORATION**
**2222 Oume Drive**
**San Jose California 95131(US)**

(72) Inventor: **Ratnakumar, Kola Nirmal**
**1048 Harlan Drive**
**San Jose, California(US)**

(74) Representative: **Ouest, Barry et al**
**M'CAW & Co.**
**41-51 Royal Exchange**
**Cross Street**
**Manchester M2 7BD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.6/3.3.1)

## Description

The present invention relates to a process for forming, on a single wafer, p- and n- channel MOS transistors along with vertical, isolated NPN and PNP transistors.

Currently CMOS is the dominant IC technology. It combines a high density of transistors with low power dissipation and high yield (due to its low sensivity to semiconductor crystal defects.) Bipolar transistors, on the other hand, are faster with larger current drive, but consume more power and have lower VLSI yield. Integration of isolated vertical NPN transistors into a CMOS process results in faster bipolar performance. By retaining the majority of the transistors in CMOS, the low power and high yield of a CMOS process are maintained.

In analog circuits, isolated NPN transistors increase the bandwidth of Opamps five-fold compared to pure CMOS implementation. They also help in easier realization of bandgap voltage references. The addition of isolated, vertical PNP transistors to the NPN's constitutes the Complementary BiCMOS process. The bandwidths of Opamps is now increased by an additional factor of at least two. Circuit noise and settling time are less. Bias generators are easily realized. It also achieves rail-to-rail analog output with low distortion combined with capability to source or sink high currents.

It is more difficult to integrate isolated vertical PNP transistors into a CMOS process (non-isolated PNP transistors are connected to the P substrate or a P epitaxial layer and are more easily implemented).

The formation of a vertical PNP transistor and a CMOS process without using a buried P+ layer is suggested by Sullivan in U.S. Patent No. 4,507,847. However, Sullivan does not provide details on how this could be accomplished.

A structure which can provide non-isolated vertical PNP transistors in a CMOS process is discussed in Y. Okada, et al., "An Advanced Bipolar-MOS-i$^2$l Technology With a Thin Epitaxial Layer for Analog-Digital VLSI", IEEE Transactions on Electron Devices, Vol. Ed.-32; No. 2, Feb 1985, pp. 232-236.

The following is a list of Complementary Bipolar Processes with isolated Vertical PNP's:

I. P.C. Davis, J.F. Graczyk and W.A. Griffin, "High Slew Rate Monolithic Operational Amplifier Using Compatible Complementary PNP's", IEEE J. Solid-State Circuits, Vol. SC-14, Vol.2, Feb 1979.

II. T. Kekkawa, T. Suganuma, K. Tanaka and T. Hara, "A New Complementary Transistor Structure for Analog Integrated Circuits", Int'l Solid State Circuits Conf. Tech Digest, 1980 p. 65-68.

III. D. Monttcelli, J. Wright, B. Small and B. Geczy, "200 MHz PNP Transistors Spawn Fast Analog Chips", Electronic Design, Aug 1986, p. 111-116.

IV. "First ADI CB Process Part is High Speed 12-Bit DAC Electronic Engineering Times. Monday, September 7, 1987.

The vertical PNP transistors in the above references are formed through a buried P+ collector which is created by a P+ implant before the growing of an N epitaxial layer.

A BiCMOS process with lateral NPN and PNP transistors is shown in U.S. Patent No. 4,050,965.

A number of references disclose the formation of vertial NPN transistors only, with no PNP transistors, such as U.S. Patent Nos. 4,547,791; 4,536,945; 4,346,512; 4,016,596; and 4,299,024.

US-A-4,637,125 describes a method of forming CMOS transistors including vertical PNP and NPN bipolar transistors in the same wafer.

According to the present invention, there is provided a method for forming CMOS transistors and NPN transistors on a single wafer, said method including the steps of forming an N well as the collector of an NPN vertical transistor, and forming an isolated, vertical PNP transistor including implanting N type material to form an N base of said PNP transistor, and forming a P region as an emitter of said PNP transistor characterised in that:

an N-well is formed to contain said PNP transistor during said step of forming the NPN vertical transistor collector; and

a P type material is implanted at an energy greater than 300 keV for singly ionized material or greater than 150 keV for doubly ionized material to form a collector of said PNP transistor.

The high energy P implant gives a peak at approximately 0.8um below the surface to form the equivalent of a buried layer (without growing an epitaxial layer after a P implant to form a buried layer as in the prior art). The advantages of a sharp profile of the high energy P implant are maintained by performing this step near the end of the process to prevent the profile from being flattened by subsequent thermal steps.

A flat base profile improves the devices' performance and is preferably provided by doing the N base implantation early in the process and allowing the temperature of later steps to drive the implanted ions deeper to provide a flat profile.

The complementary BiCMOS process of the present invention is one which integrates complementary, isolated vertical PNP and NPN bipolar transistors with complementary MOS transistors on the same silicon chip. Both the vertical NPN and PNP transistors have a high transition frequency (fT)> 1 (GHz). Also, both of them have excellent current drive capabilities of the order of 1 mA/100 $um^2$ (even without the addition of an N+ buried layer for the NPN's.) Thus, the process combines the high speed, excellent linearity and large bandwidth of complementary bipolar circuits with the high packing density and low power consumption of complementary MOS transistor circuits. It also results in a lower settling time for switching, and lower noise compared to either CMOS or BiCMOS with NPN transistors only. Also, the complementary bipolar transistors permit nearly rail-to-rail swings for linear signals with low distortion.

The complementary BiCMOS process of the present invention adds three additional non-critical masks and implants to an existing 11 mask, double poly, single metal, N-well CMOS process. Thus, it is a 14 mask process. However, there are no additional process steps except for the three masked implants listed below:

1. P-Base Implant Mask (For the base of Vertical NPN)
2. N-Base Implant Mask (For the base of Vertical PNP)
3. P-Collector Implant Mask (For the collector of Vertical PNP, could be combined with step 1)

For a fuller understanding of the nature and advantages of the invention, reference should be made to the ensuing description take in conjunction with the accompanying drawings.

Fig. 1 is a cross-sectional diagram showing the N and P channel MOS transistors and the vertical isolated NPN and PNP transistors according to the present invention;

Figs 2A and 2B are cross-sectional and layout views, respectively, of a PNP transistor of Fig. 1;

Figs. 3A and 3B are cross-sectional and layout views, respectively, of the vertical NPN transistor of Fig. 1;

Fig. 4 is a graph of the impurity profile for an N-Base implant just before the emitter implant;

Fig. 5 is an impurity profile of a process in which the N-Base Mask follows immediately after the field implant;

Fig. 6 is an impurity profile showing the P-Collector of a vertical PNP transistor which is driven down from the top surface;

Fig. 7 shows an impurity profile resulting from a high energy Boron implant;

Fig. 8 is an impurity profile illustrating the merging of the P+ emitter with the P-Collector;

Fig. 9 is an impurity profile illustrating a shallow P+ emitter junction according to the present invention through a low energy $BF_2$ implant;

Fig. 10A is an impurity profile of a current complementary bipolar process as set forth in Ref. II;

Fig. 10B is an impurity profile for the complementary BiCMOS process of the present invention shown to the same scale as Fig. 10A;

Fig. 11A is a cross-sectional view of a complementary vertical PNP transistor according to the prior art; and

Fig. 11B is a cross-sectional view of a vertical PNP transistor according to the present invention drawn to the same scale as Fig. 11A.

The BiCOMOS process of the present invention, showing the new steps, is set forth in the Appendix.

Fig. 1 generally shows the structure resulting from the process of the present invention. In addition to an N-MOS transistor 12, a P-MOS transistor 14 and a vertical NPN transistor 16 (which have been produced in the prior art), the present invention also produces a vertical PNP transistor 18. A P substrate or P epitaxial layer 20 is first provided, and 3 N-wells 22, 24 and 26 are produced in step M #1 (see Appendix). N-Base 28 or PNP transistor 18 is then produced, followed by the implantation of the P-Base 30 for NPN transistor 16. The N+ source 32 and drain 34 of N-MOS transistor 12 are then produced, along with N+ emitter 36 of NPN transistor 16 and N+Base contact 38 of PNP transistor 18. The high energy implantation to produce P collector 40 is then done. This is followed by the P+ diffusion for source 42 and drain 44 of P-MOS transistor 14, base contact 46 of NPN transistor 16 and emitter 48 and collector connection 50 of PNP transistor 18. The field oxide, metalization and other steps, are produced in a standard manner as set forth in the Appendix.

The preferred structure of PNP transistor 18 is shown in Figs. 2A and 2B in cross-sectional and top views, respectively. The numbering corresponds to that of Fig. 1. Also shown is an additional P+ region 52 for coupling to the P substrate 20 and an N+ region 54 for coupling to N well 26.

Figs. 3A and 3B show a preferred embodiment of NPN transistor 16 of Fig. 1 with cross-sectional and top views, respectively. The numbering is the same as set forth in Fig. 1. In addition, an N+ collector contact 56 is shown.

A high fT vertical PNP transistor is unique to this BiCMOS process. Details of fabrication of this device are now described. The usual implementation of high performance vertical PNP transistors involves complex

process steps which reduce yield, such as double epitaxy, etc. A feature of the process described here is that it involves three (or two) additional masked implant steps only, i.e., an N-Base implant mask and a P-Collector implant mask. This gives two advantages:

A. Principal device parameters such as current gain HFE, BVCEO and collector resistance can be easily adjusted by optimizing the dose and energy of these two or three implants.

B. Besides the masks and implants, there are no additional thermal/deposition/etching steps.

This yields:

(i) The same characteristics and SPICE model parameters for P and N channel MOS transistors and vertical NPN transistors with or without the PNP transistors. The circuit performance of these devices remains unchanged.

(ii) The yield is not affected since the masking steps are non-critical.

Each of these implant steps and its optimization are now described.

The P+ and N+ source/drain implants for the CMOS transistors form the P+ and N+ emitters of the PNP and NPN transistors, respectively. The N-well forms the collector of the NPN transistor and serves to isolate the P-collector of the PNP from the P-substrate or P-Epi on P-substrate. The N-well can merge with a N+ buried layer for higher NPN drive capability through a N+ buried layer implant and drive into a P-substrate and a subsequent P-Epi.

The P-Base Implant for the NPN and P-Collector Implant of the PNP can be combined to eliminate one additional mask and implant reducing it to a 13 mask process. Therefore only the additional N-Base and P-Collector masked implant steps are explained here. The rest of the steps are same as in a conventional CMOS process.

N-Base Implant:

Simulations have been done for the optimum location of the N-Base Phosphorus implant in the process sequence. It is introduced early in the process, i.e., after the N-well drive and just prior to growing the gate oxide of the CMOS transistors. Thus, the N-Base is driven deep by subsequent thermal steps. If necessary, the drive can be increased without affecting the threshold adjust implants of the CMOS transistors, since these are implanted after the gate oxide. This deep drive gives a relatively flat implanted N-base impurity profile, leading to greater control and less sensivity to process variations, compared to a much steeper N-base profile if this implant were to be done later. In order to have a reasonable Emitter-Base breakdown voltage (BVEBO), the surface concentration of the implanted phosphorus must be less than 3E18/cc which corresponds to a typical dose of from 3E13 to 1.5E14/sq.cm.

The N-Base implant dose and energy have a dominant influence on the following parameters:

1. The emitter-base reverse breakdown voltage (BVEBO) through the P+ Emitter N-Base junction at the surface;

2. The common emitter current gain HFE, which can be shown to be :

$$HFE = \frac{\gamma E}{\gamma B}$$

where $\gamma E$ and $\gamma E$ are the emitter and pinched base sheet resistance, respectively;

3. Collector resistance (RC) which is dominated by the pinched collector sheet resistance;

4. The emitter saturation current ($I_s$)

$I_s \propto QB$

5. VAF = Early Voltage $\propto 1/\gamma$ B

6. fT, which varies inversely with the square of base width.

The location of the N-Base implant in the process sequence is also of considerable importance. Figs. 4 and 5 depict two hypothetical impurity profiles. The one in Fig. 4 corresponds to an N-Base implant just before the emitter implant, followed by minimum thermal steps. Consequently, both the emitter and base profiles are abrupt. If the P collector is also an implanted retrograde profile as illustrated, then there would be 3 abrupt impurity profiles. Any slight change in any of the three implant doses or energies would result in a major change in pinched base sheet resistance and would change all the device parameters listed

above.

One other disadvantage of doing the N-Base implant just before the P+ S/D implant is the large difference between the individual implanted phosphorus profile and the much smaller net concentration in the N-Base region after compensation by Boron from the P collector and P+ emitter. This is because the implanted impurity peak lies inside the emitter even after a high energy phosphorus implant. Consequently, the peak phosphorus concentration is high (approximately 3-5 x $10^{18}/cm^3$ and BVEBO is rather low. Therefore, an N-Base implant done just before BPSG densification and reflow (Appendix) has the demerits of large sensitivity to process fluctuations, low BVEBO and high emitter base junction capacitance.

The profile shown in Fig. 5 results from the process flow listed in the Appendix. In this one, the N-Base mask follows immediately after the Field implant. The implanted base is driven deep (to a depth of about 1.2um at a concentration of 1 x $10^{16}/cm^3$) due to subsequent high temperature steps such as gate oxide, interpoly oxidation at 1140°c etc. Therefore, the base impurity profile is approximately constant or flat over the final N-Base region (0.25 t 0.45/um depth). Moreover, it is not sensitive to the BPSG flow and reflow conditions since the thermal Dt's associated with these steps are so much smaller compared to other high temperature steps such as interpoly ox., etc. Hence, a relatively stable individual base profile results. The typical base implant dose is in the range of 3 x $10^{13}$ to 1 x $10^{14}/cm^2$ with a surface concentration in the range of 5 x $10^{17}$ to 2 x $10^{18}/cm^3$. This corresponds to BVEBO in the range of 10 to 4V, which is quite adequate. In this scheme, the final net base charge is affected by compensation due to the P+ emitter profile diffusing down from the top surface and the a P collector profile (a retrograde one achieved by a high energy Boron implant) "pinching" from below.

P-Collector

The way in which this implant is done is one factor that distinguishes this process and contributes to a successful implementation which gives a low collector-to-emitter punchthrough voltage. A low/medium energy Boron implant for this step would result in 4 implants diffusing into the P-substrate/P-Epi: 1. N-well, 2. P-Collector, 3. N-Base, and 4. P+ Emitter. This would result in a net collector concentration of the order of 1E16/$cm^3$ and a depth of 1um, resulting in an extremely high pinched collector resistance and severely limiting the current drive capability.

Instead, the P-collector is implanted at a very high energy (greater than 150 kV, preferably 180-200 kV Boron implant by using doubly ionized Boron or greater than 300 keV using singly ionized Boron). The resultant peak lies at a depth of about 0.8um below the surface, forming a P+ buried collector well. The retrograde P-collector combines a low series resistance with a smaller collector-base junction capacitance due to reduced collector doping at the junction. To maintain this advantage, the profile must not be flattened by out-diffusion from subsequent thermal steps. Therefore, the implant is done just before the PSG/BPSG deposition and sees only the bare minimum thermal drive necessary for the doped oxide to flow. To keep the P+ emitter shallow so that the N-base width will not be too small, the masked P+ S/D implant is also done at this stage as shown in the Process Sequence Table (Appendix). For the same reason, this implant uses a Boron (BF2) species to give a shallower P+/N-base junction than would be given by a Boron implant at the same energy.

An implanter operating at 200kV can accelerate the doubly ionized boron species to the same energy as 400kV for singly ionized Boron. As a matter of practical detail the dose must be mulitplied by a factor of 2 since each Boron ion has twice the charge.

The need for this high energy retrograde P-Collector profile is obvious with reference to Figs. 6 and 7. In Fig. 6 the individual and total (net) impurity profiles when the P-Collector is driven down from the top surface are shown. In this scheme there are 4 diffusions, P+ Emitter, N-Base, P-Collector and N-Well, resulting in complex compensations. The final base and collector charges are low. Since the P-Collector surface concentration has to be in between that of the N-Base (approx. 1 x $10^{18}/cm^3$) and the N-Well (1x$10^{16}/cm^3$), and its junction depth is also limited. Therefore, even the uncompensated collector charge is very small (approx. 1 x $10^{13}$ atoms/$cm^2$). The pinched collector resistance is extremely high and severely limits the current drive capability of this device.

The retrograde profile for the P-Collector (Fig. 7) resulting from a high energy Boron implant (approx. 360-400 keV) is equivalent to a P+ buried collector. It yields the following desirable device characteristics:

1. Low collector series resistance. Notice that the collector peak concentration is about $10^{19}/cm^3$, about two orders of magnitude higher than the previous scheme (Fig. 6). Only a small fraction of this charge is lost due to compensation by the N-base and N-Well implants. This in turn increases the current drive capability of this transistor.

2. The retrograde Boron profile for the collector increases the collector-base junction breakdown voltage while decreasing the capacitance of this junction.

The peak of the P-Collector lies at a depth of 0.7 to 0.8um for an implant energy in the range of 380-400 keV and the P-Collector - N-well junction depth is about 1.2um. The typical P-Collector implant dose is in the range of 2 x $10^{13}/cm^{-2}$ to 2 x $10^{14}/cm^{-2}$. The lower limit is set by the conditions that it must be larger than the N-well dose and by the condition that the pinched (buried) collector sheet resistance must not be too large in order to reduce the Ic*Rc voltage drop. If the P-Collector dose is increased, due to the standard deviation of the implant and diffusion during BPSG flow and reflow, it counter dopes the N-Base and increases the base sheet resistance. Eventually, punchthrough from collector to emitter occurs at a voltage less than that of the avalanche breakdown voltage of the collector-base junction. Finally, at a high enough collector dose, the P+ emitter and P-collector merge together with a small ohmic resistance.

The pinched collector sheet resistance varies from 1000 to 200 ohms/square. These are low enough that even a small geometry device can carry several milliamps of collector current before the C-B junction gets forward biased due to the IcRc drop.

P+ Emitter Implant

As pointed out earlier, the peak of the collector implant lies only at a depth of 0.7um. Therefore, the N-Base/P-Collector junction depth must be less than 0.5um.

However, a $B^{11}$ Boron implant, even at a low energy or 40 keV, has a large range and standard deviation so that the P+/N-Base junction depth is also approximately 0.5um. Therefore, as illustrated in Fig. 8, the P+ emitter and P-Collector merge.

A P+ emitter implant using $BF_2$ at a low energy of from 40 to 60 keV is much shallower. This is because $BF_2$ dissociates into $B^{11}$ and $F_2$ on impact and the resultant $B^{11}$ has energy of only 11/49 times the energy of the $BF_2$ ion.

Thus, a $BF_2$ implant at 49 keV is equivalent to an 11 keV B″ implant. Both the range and the standard deviation are therefore proportionately smaller, resulting in a shallower P+ emitter junction (0.25 to 0.3um). This as illustrated in Fig. 9, which shows the separation of the emitter from the P-Collector, allowing for an N-Base which is approximately 0-1 to 0-2um wide. The P+ emitter $BF_2$ implant can also be replaced by a low energy Boron implant, i.e., $B^{11}$ at less than 15 keV.

There are two precautions to be observed in this process in order to avoid a base punchthrough:

1. In order for the low energy $BF_2$ implant to penetrate the oxide thickness, this implant screening oxide must be in the range of 100-300 angstroms.

2. To minimize the diffusions of the P+ emitter and the P collector, subsequent thermal steps should use minimum temperature and time.

For example, the BPSG flow (densification) and reflow times are cut in half compared to the standard times for this process. This is also the reason why the P collector and P+ emitter implant (Appendix) are done one after the other with no thermal step in between.

Comparison of Invention to Other Processes

Bipolar Processes.

The isolated vertical PNP transistor (VPNP) is the structure that allows the integration of complementary bipolar and CMOS on the same chip of silicon. This element is not available in other existing BiCMOS processes. However, a different version of it is available in pure complementary bipolar processes. However, the structure in the new scheme is vastly superior in the following aspects:

A. Much smaller size;

B. Simpler process with higher yield and reliability; and

C. Better and easier device optimization.

The principal differences in the process technology for the formation of VPNP in the present invention and these prior art complementary bipolar processes are as follows:

Present Invention: The P+ collector is formed by a high energy implant of doubly ionized boron atoms followed by minimum temperature steps. This leads to a buried P+ collector profile with the peak at a depth of 0-6 to 0.8um and a very low concentration near the surface. There is very little lateral diffusion.

This, combined with a shallow implanted P+ emitter formed by a $BF_2$ implant, gives a compact high performance VPNP whose fT of >2GHz is higher by a factor of 3 over the 700 MHz reported in Ref. IV (see Background Section), and a factor of 7 over the 300 MHz of Ref. III. This size is only 1/4 their size.

Prior Art: The VPNP in the complementary bipolar processes, on the other hand, is formed through a buried P+ collector through a P+ implant before epitaxy. This leads to larger size and process complications through auto doping due to the presence of both N+ and P+ buried layers.

To start with, we compare the final impurity profiles in our process (simulated and verified by spreading resistance profiles with the one reported by T. Kikkawa, et al. (Ref. II).

The impurity profiles of the VPNP in the current complementary bipolar (CB) (Ref. II) and the one in the new complementary BiCMOS (CBiCMOS) of the present invention are sketched to the same scale in Figs. 10A and 10B, respectively. While the peak impurity concentrations in the emitter, base and collector are approximately the same, the junction depths are smaller by an approximate factor of 7 for the present invention. This is also reflected in Table 1 below.

Table 1

| Comparison of Peak Impurity Concentrations and Junction Depths in the New CBiCMOS Pure CB Processes | | | | |
|---|---|---|---|---|
| Region | Junction Depths um) | | Peak Impurity Concen. ($cm^3$) | |
| | New CBiCMOS | CB | New CBiCMOS | CB |
| | um | um | $cm^3$ | $cm^3$ |
| P+ Emitter | 0.2 | 2.0 | $10^{20}$ | $7x10^{18}$ |
| N Base | 0.4 | 3.0 | $3x10^{17}$ | $3x10^{17}$ |
| P Collector | 1.2 | 22.5 | $3x10^{18}$ | $3x10^{18}$ |
| N-Well (for Isolarion from P sub) | 4.0 | 28.5 | $1.5x10^{16}$ | $1.5x10^{16}$ |

The small junction depths for the present invention result in smaller lateral spreads and therefore smaller device sizes. In addition, the parasitic capacitances are smaller. The small emitter junction depth gives a flat current gain down to 100pA of collector current and the small base width gives a much higher fT. At Ic=1mA, the measured fT is greater than 2GHz.

The device cross-sections of the VPNP in the conventional complementary bipolar (CB) process and the new CBiCMOS process of the present invention are shown in Figs. 11A and 11B, respectively. They are drawn on approximately the same scale and assume the same lithography tolerances and depletion widths. For the same P+ emitter width of 6um, the VPNP in the new scheme is smaller by a factor of two per side and therefore occupies only a quarter of the area required for the VPNP in the CB process. This is again due to the much shallower junction depths for the new scheme as illustrated in Figs. 10A and 10B.

Comparison of Process Complexity. In the new Complementary BiCMOS scheme of the present invention, the P collector is formed by a high energy boron implant just prior to the P+ emitter impact. It does not need any extra thermal or process steps besides the usual CMOS flow after the P+ S/D implant. The P+ collector is isolated from the P substrate by the N-Well as in the conventional CMOS process.

The P collector in the CB processes is formed, on other hand, by introducing a P+ buried layer, which in turn is isolated from the P- substrate by a very deep N-Well (junction depth of approx. 30um from the top surface and approx. 16um from the epi/substrate interface). Besides the increase in size, the deep buried P+ collector causes two significant process problems:

1) Auto Doping during Epitaxy:

The vertical NPN transistor needs an Arsenic or Antimony doped N+ buried layer to reduce its collector. Now, in addition, the CB process also has a heavily doped P+ buried layer.

During epitaxy, the dopant atoms in the buried layers come out and alter the desired epi doping by getting incorporated. This is known as autodoping and in extreme cases can change N type epi into P type or vice versa. While the autodoping of N type impurity species such as Arsenic can virtually be eliminated by going to reduced pressure epitaxial reactors, autodoping due to Boron has no such cure. This poses a serious restriction on the minimum doping of the N epi and compromises the breakdown voltages and parasitic capacitances of both NPN and PNP transistors.

2) High-Temperature N-Well Drive:

The isolation N-Well must be driven to a very large junction depth (approx. 15um). This entails a long, high temperature drive which is incompatible with modern IC processes. Such a drive will cause pattern distortion due to wafer warpage and limit the use of fine line lithography.

The N-Well also increases the P+ buried layer sheet resistance due to counter doping. It must also be pointed out that the structure outlined by Analog Devices (Ref. IV) uses a different process variant. The conventional CB processes start with P type substrate, N type Epi and P-wells for top and bottom isolation. In the process described in IV these are reversed, i.e., the starting material is N-substrate followed by P-Epi and N-Wells for top and bottom isolation. The vertical NPN transistor is the analog of the VPNP in the conventional CB process. Its N+ buried layer is isolated from the N substrate by a deep P-Well.

The cross-section of the vertical NPN is very similar to the one sketched in Fig. 11A, with the N type and P types interchanged.

Therefore, the prior art process suffers from the same disadvantages common to other CB processes, i.e. large size due to deep junctions, simultaneous P+ and N+ buried layers and a very deep P-Well for isolation.

Summary of Advantages of the Present Invention

1. Shallower junctions and profiles which result in:
   a) Smaller size (one quarter the area of conventional CB process);
   b) Higher fT's (greater by a factor of at least 3); and
   c) Smaller capacitances.
2. Simpler epitaxy with higher yield because there is no Boron doped P+ buried layer. CB processes need both N+ and P+ buried layers.
3. No deep isolation well. A regular CMOS N-Well is sufficient. Therefore, it is a modern fine feature IC process which minimizes high temperature steps.
4. Has same process flow as CMOS, therefore complementary bipolar and complementary any MOS transistors can be combined on the same chip.
5. Optimization of NPN's, PNP's and MOS transistors are independent and gives a flexible, high yield IC process.

Simulations have shown that the device of the present invention will have the following characteristics: $H_{FE}$ = 50 to 100, BVCEO (Vpt) > 10V, BVCBO > 10V and fT = 1 to 2 GHz.

Adding N+ Buried Layers. The device described so far has been implemented in a conventional CMOS process. In a BiCMOS process, to improve the drive capabilities of the vertical NPN, the collector series resistance must be reduced. This is done by incorporating an N+ buried layer 58 (see Fig. 1) in the front end.

The starting material is a P type substrate4 instead of a P+ substrate. The additional steps are listed below:

Starting Material: P-sub ⟨100⟩
- N+ Buried Layer Mask
- N+ Buried Layer Implant Arsenic/Antimony
- N+ Buried Layer Drive
- P Type Epitaxial Layer 60
- N Well Mask

The rest of the steps are the same as in the Appendix. The N+ Buried Layer and N-Well form an isolating structure in the P Epi or P substrate. There is one extra mask in the above scheme, i.e. the N+ Buried Layer Mask.

## APPENDIX

### Complementary Bipolar & CMOS Process Sequence

- P-Epi on P+ Sub/PSub (starting Material)

M#1
- N-Well Mask
- N-Well Implant $P^{31}$
- N-Well Drive
- Nitride Deposit

M#2
- Active Mask
- Nitride Etch

M#3
- N Field Implant Mask
- N Field Implant $B^{11}$
- Optional: P Field Mask
- PreGate Ox. P Field Implant $P^{31}$

(New)
M#4
- N-Base Mask
- N-Base Implant $P^{31}$
- Gate Ox.
- $V_T$ Implant $B^{11}$

M#5
- PMOS $V_T$ Implant Mask (Optional)
- PMOS $V_T$ Implant $B^{11}$

(New)
M#6
- P-Base Implant Mask
- P-Base Implant $B^{11}$
- Poly 1 Deposit & Dope
- Poly 1 Interpoly Ox.
- Interpoly Nitride Deposit

M#7
- Poly 1 Mask
- Plasma Nitride/oxide/Poly 1 Stack Etch

- Poly 1 Edge Ox.
- Poly 2 Deposit & Dope

M#8 - Poly 2 Mask
- Poly 2 Etch
- Pre S/D Implant Ox.

M#9 - N+ S/D & N+ Em-Implant Mask
- N+ Implant $As^{75}$
- High Volt. Implant $P^{31}$
- Poly 2 Ox.

(New)
M#10 - P+ Collector Mask
- P+ Collector Implant $B^{11}$ (Doubly ionized)
(This step could be combined with M#6)

M#11 - P+ S/D & P+ Em Mask
- P+ S/D Implant $BF_2$ (or Low Energy $B^{11}$)
- BPSG Deposit
- BPSG Density

M#12 - Contact Mask
- Plasma Contact Etch
- BPSG Reflow
- Metal Sputter

M#13 - Metal Mask
- Plasma Metal Etch
- Passivation Oxy - Nitride Deposit

M#14 - Pad Mask
- Plasma Pad Etch
- Alloy

## Claims

1. A method for forming CMOS transistors and NPN transistors on a single wafer, said method including the steps of forming an N well (24) as the collector of an NPN vertical transistor (16), and forming an

isolated, vertical PNP transistor (18) including implanting N type material to form the N base (28) of said PNP transistor (18), and forming a P region as the emitter of said PNP transistor (18), characterised in that:

an N-well (26) is formed to contain said PNP transistor (18) during said step of forming the NPN vertical transistor collector (24); and

a P type material is implanted at an energy greater than 300 keV for singly ionized material or greater than 150 keV for doubly ionized material to form the collector of said PNP transistor (18).

**2.** The method of claim 1 characterised in that said N base (28) is implanted at a dosage of between 3 x $10^{13}$ and 1.5 x $10^{14}/cm^2$.

**3.** The method of claim 2 characterised in that said N type material for said N base (28) is phosphorous.

**4.** The method of claim 1 characterised in that said N base (28) is formed before said collector of said PNP transistor (18).

**5.** The method of claim 1 characterised in that said emitter of said PNP transistor (18) is a shallow P+ region less than 0.35um thick.

**6.** The method of claim 1 characterised in that the doubly ionized material used is Boron.

**7.** The method of claim 1 characterised in that said PNP emitter is formed in the same step as a formation of a P+ source and drain for said CMOS transistors.

**8.** The method of claim 1 characterised in that said PNP collector is formed in the same step as a P base (30) of said NPN transistor.

**9.** The method of claim 1 characterised by the steps of:

implanting an N+ buried layer (58) below said N-well (24); and

growing a P type epitaxial layer (60).

**Patentansprüche**

**1.** Verfahren zur Herstellung von CMOS-Transistoren und NPN-Transistoren auf einer einzigen Halbleiterscheibe, mit den Verfahrensschritten: Herstellung einer N-Wanne (24) als Kollektor eines vertikalen NPN-Transistors (16) und Herstellung eines isolierten, vertikalen PNP-Transistors (18), wobei Material vom Typ N zur Bildung einer N-Basis (28) des PNP-Transistors (18) implantiert wird, sowie Herstellung einer P-Region als Emitter des PNP-Transistors (18), dadurch gekennzeichnet,

daß während des Verfahrensschrittes zur Herstellung des Kollektors (24) des vertikalen NPN-Transistors eine N-Wanne (26) zur Aufnahme des PNP-Transistors (18) hergestellt wird,

und daß zur Herstellung des Kollektors des PNP-Transistors (18) Material vom Typ P implantiert wird mit einer Energie größer als 300 keV für einfach ionisiertes Material oder größer als 150 keV für doppelt ionisiertes Material.

**2.** Verfahren nach Anspruch 1,
dadurch gekennzeichnet, daß die N-Basis (28) mit einer Dosis von 3 x $10^{13}/cm^2$ bis 1,5 x $10^{14}/cm^2$ implantiert wird.

**3.** Verfahren nach Anspruch 2,
dadurch gekennzeichnet, daß das Material vom Typ N für die N-Basis (28) Phosphor ist.

**4.** Verfahren nach Anspruch 1,
dadurch gekennzeichnet, daß die N-Basis (28) zeitlich vor dem Kollektor des PNP-Transistors hergestellt wird.

**5.** Verfahren nach Anspruch 1,
dadurch gekennzeichnet, daß der Emitter des PNP-Transistors (18) eine flache $P^+$-Region von weniger als 0,35 $\mu$m Dicke ist.

6. Verfahren nach Anspruch 1, dadurch gekennzeichnet, daß das doppelt ionisierte Material Bor ist.

7. Verfahren nach Anspruch 1, dadurch gekennzeichnet, daß der PNP-Emitter in demselben Verfahrensschritt hergestellt wird wie die Herstellung einer $P^+$-Quelle und eines $P^+$-Drain der CMOS-Transistoren.

8. Verfahren nach Anspruch 1, dadurch gekennzeichnet, daß der PNP-Kollektor in demselben Verfahrensschritt hergestellt wird wie eine P-Basis (30) des NPN-Transistors.

9. Verfahren nach Anspruch 1, gekennzeichnet durch die Verfahrensschritte:
Implantieren einer vergrabenen $N^+$-Schicht (58) unter der N-Wanne (24); und
Züchten einer Epitaxieschicht (60) vom Typ P.

**Revendications**

1. Procédé pour la formation de transistors CMOS et de transistors NPN sur une plaquette unique, ledit procédé comprenant les étapes de formation d'un puits (24) de type N en tant que collecteur d'un transistor vertical (16) de type NPN et la formation d'un transistor (18) vertical isolé de type PNP comprenant l'implantation d'une matière de type N pour former la base (28) de type N dudit transistor (18) de type PNP et la formation d'une région, de type P en tant qu'émetteur dudit transistor (18) de type PNP, caractérisé en ce que :
   - l'on forme un puits (26) de type N pour contenir ledit transistor (18) de type PNP pendant ladite étape de formation du collecteur (24) du transistor vertical NPN; et
   - l'on implante une matière de type P à une énergie supérieure à 300 keV pour une matière à simple ionisation ou supérieure à 150 keV pour une matière à double ionisation pour former le collecteur dudit transistor (18) de type PNP.

2. Procédé selon la revendication 1, caractérisé en ce que ladite base (28) de type N est implantée avec une densité comprise entre $3 \times 10^{13}$ et $1,5 \times 10^{14}/cm^2$.

3. Procédé selon la revendication 2, caractérisé en ce que ladite matière de type N destinée à ladite base (28) de type N est phosphoreuse.

4. Procédé selon la revendication 1, caractérisé en ce que ladite base (28) de type N est formée avant ledit collecteur dudit transistor (18) de type PNP.

5. Procédé selon la revendication 1, caractérisé en ce que ledit émetteur dudit transistor (18) de type PNP est une région de type P+ peu profonde dont l'épaisseur est inférieure à 0,35 micron.

6. Procédé selon la revendication 1, caractérisé en ce que la matière à double ionisation utilisée est du bore.

7. Procédé selon la revendication 1, caractérisé en ce que ledit émetteur de type PNP est formé lors de la même étape que la formation d'une source et d'un drain de type P+ pour lesdits transistors CMOS.

8. Procédé selon la revendication 1, caractérisé en ce que ledit collecteur de type PNP est formé lors de la même étape que la base (30) de type P dudit transistor de type NPN.

9. Procédé selon la revendication 1, caractérisé par les étapes suivantes :
   - implantation d'une couche enterrée (58) de type N+ en dessous dudit puits (24) de type N ; et
   - tirage d'une couche épitaxiale (60) de type P.

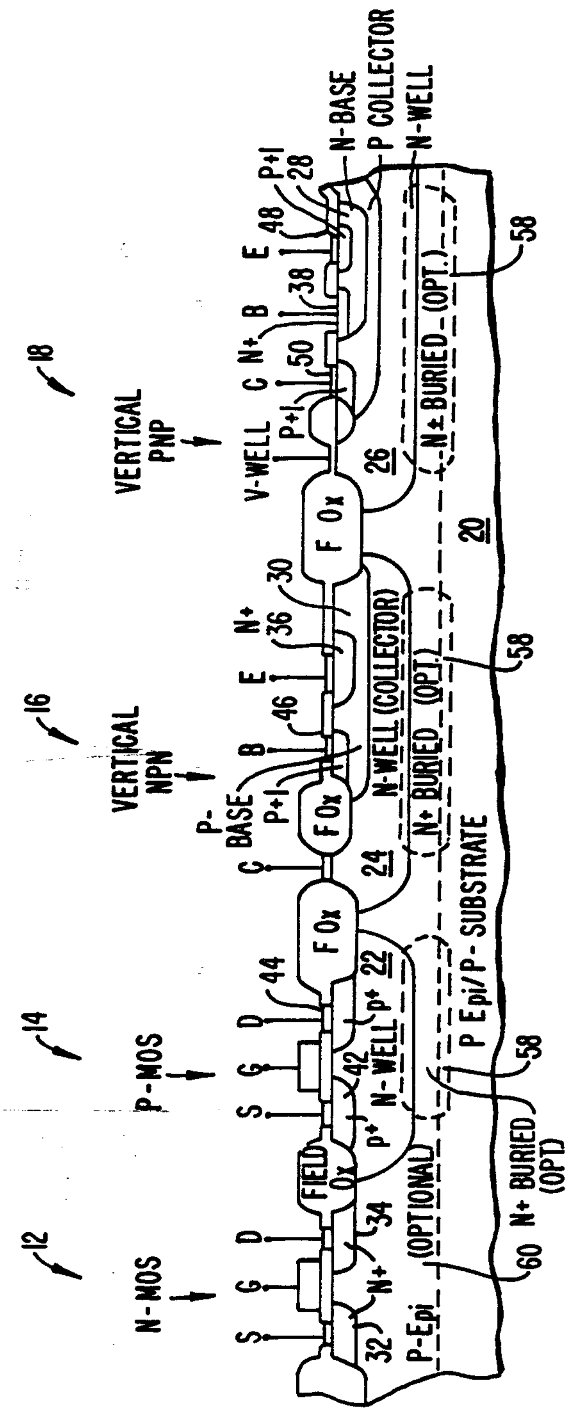
N-MOS
P-MOS
VERTICAL NPN
VERTICAL PNP
12
14
16
18
FIELD Ox
F Ox
P-Epi
(OPTIONAL)
N-WELL
N-WELL (COLLECTOR)
N+ BURIED (OPT)
N± BURIED (OPT.)
P Epi/P- SUBSTRATE
P-BASE
N-BASE
P COLLECTOR
V-WELL


FIG._1.

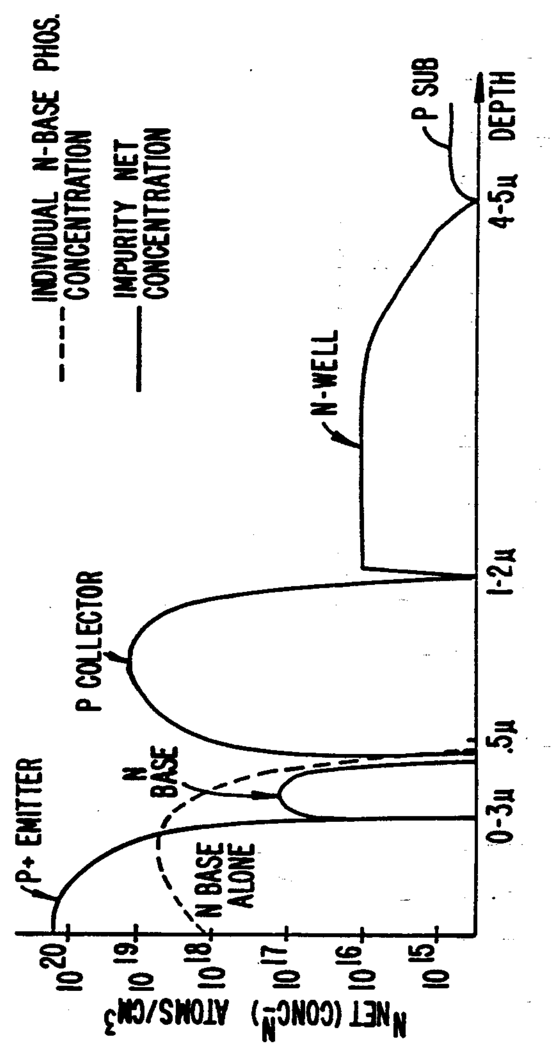
INDIVIDUAL N-BASE PHOS. CONCENTRATION
IMPURITY NET CONCENTRATION
P+ EMITTER
N BASE
N BASE ALONE
P COLLECTOR
N-WELL
P SUB
DEPTH


FIG._4.

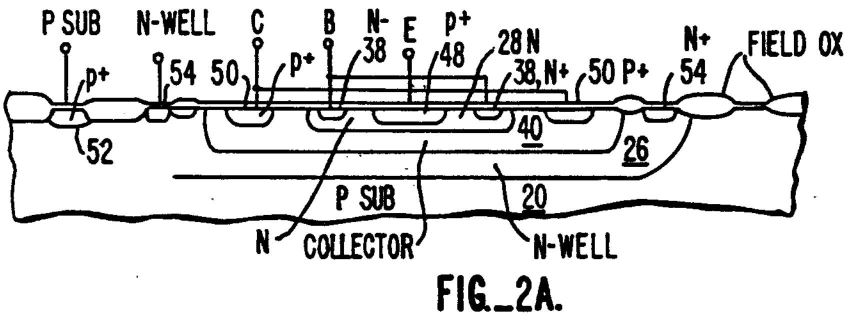
P SUB
N-WELL
C
B
N-
38
E
p+
48
28 N
38, N+
50 P+
54
N+
FIELD OX
p+
54
50
P+
52
40
26
P SUB
20
N
COLLECTOR
N-WELL

FIG._2A.

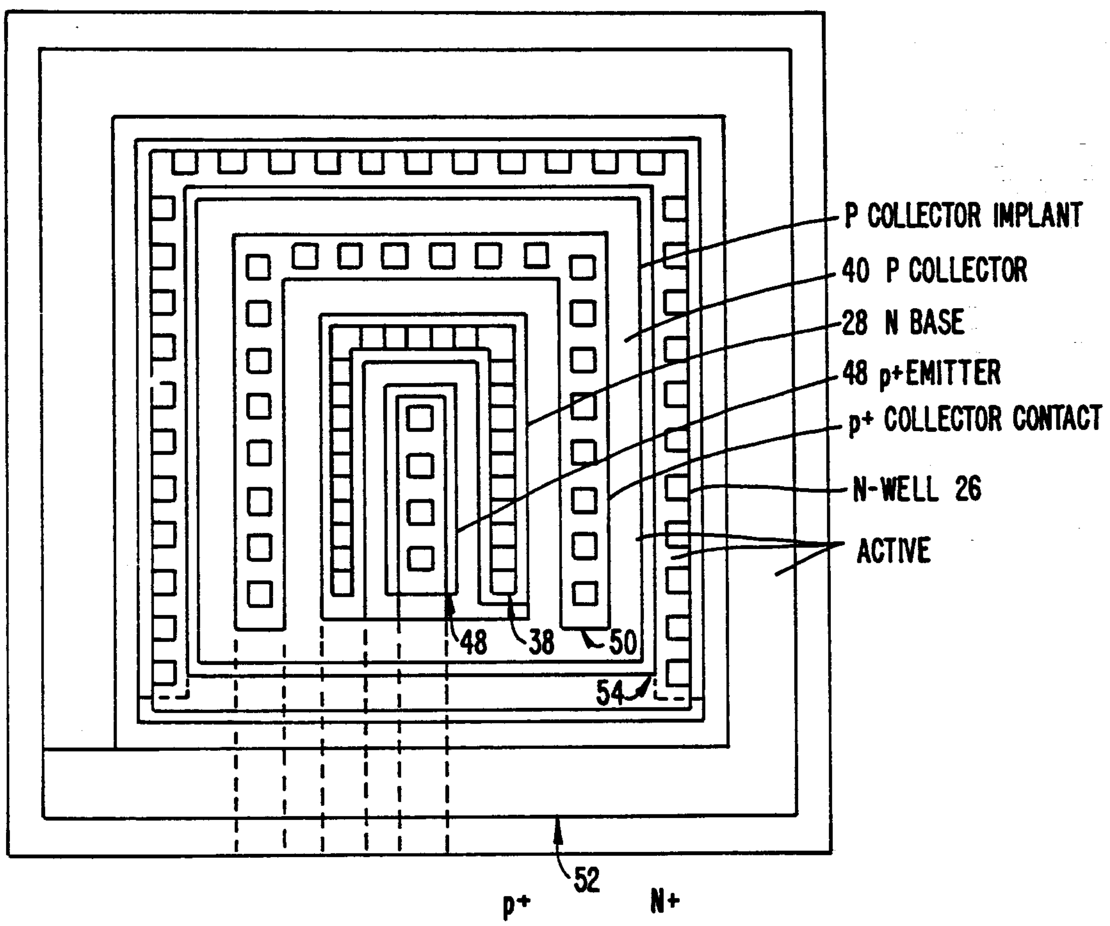
P COLLECTOR IMPLANT
40 P COLLECTOR
28 N BASE
48 p+EMITTER
p+ COLLECTOR CONTACT
N-WELL 26
ACTIVE
48
38
50
54
52
p+
N+

FIG._2B.

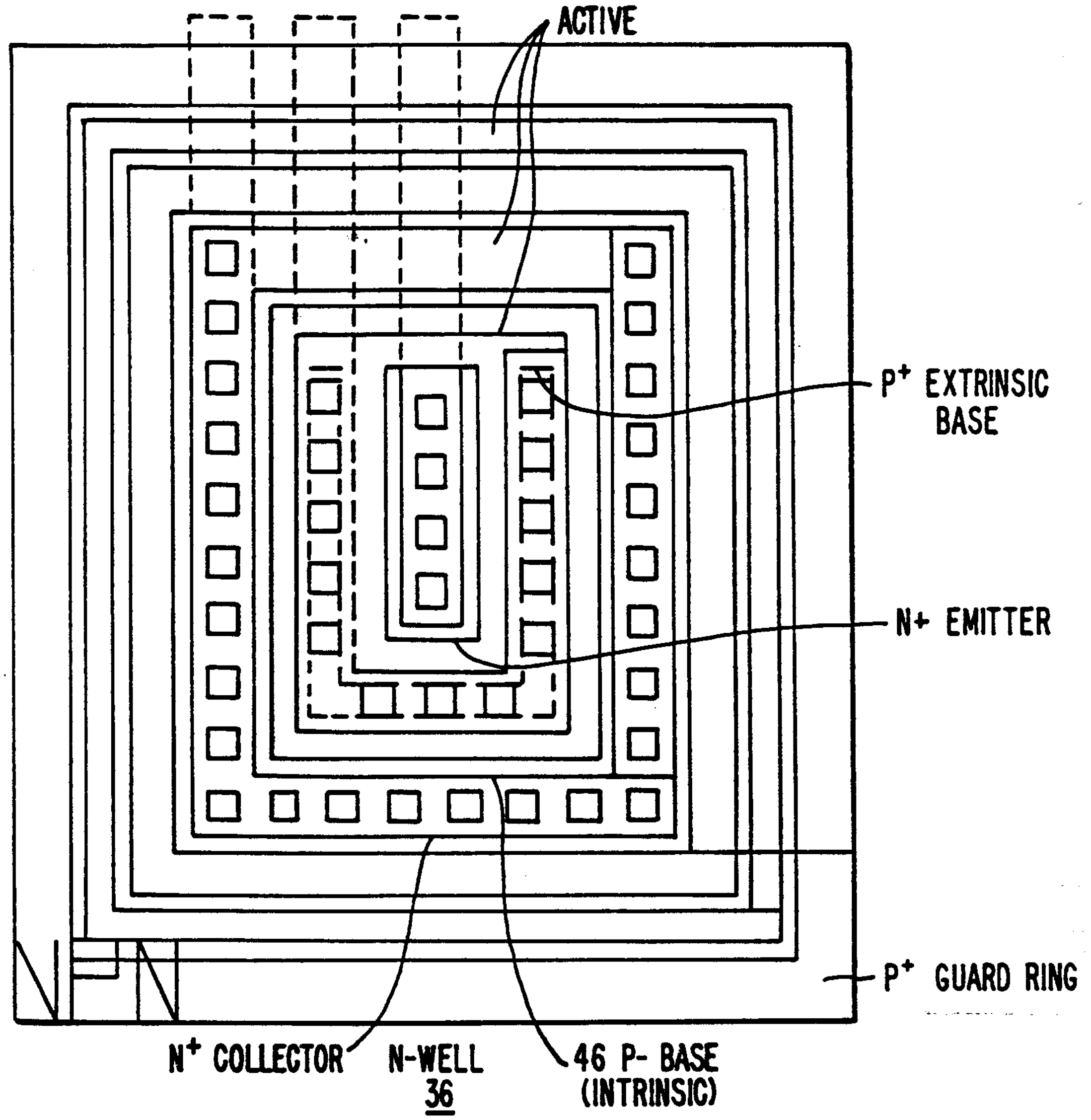
ACTIVE
P+ EXTRINSIC BASE
N+ EMITTER
P+ GUARD RING
N+ COLLECTOR
N-WELL 36
46 P- BASE (INTRINSIC)

FIG._3B.

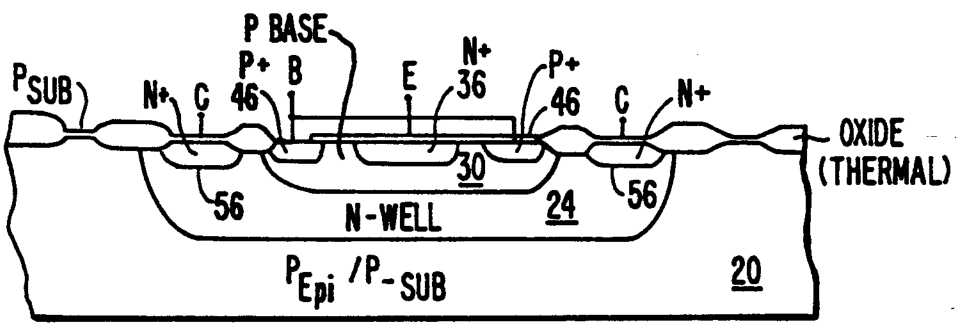
P BASE
PSUB
N+
C
P+
46
B
E
N+
36
P+
46
C
N+
OXIDE (THERMAL)
30
56
N-WELL
24
56
PEpi /P-SUB
20

FIG._3A.

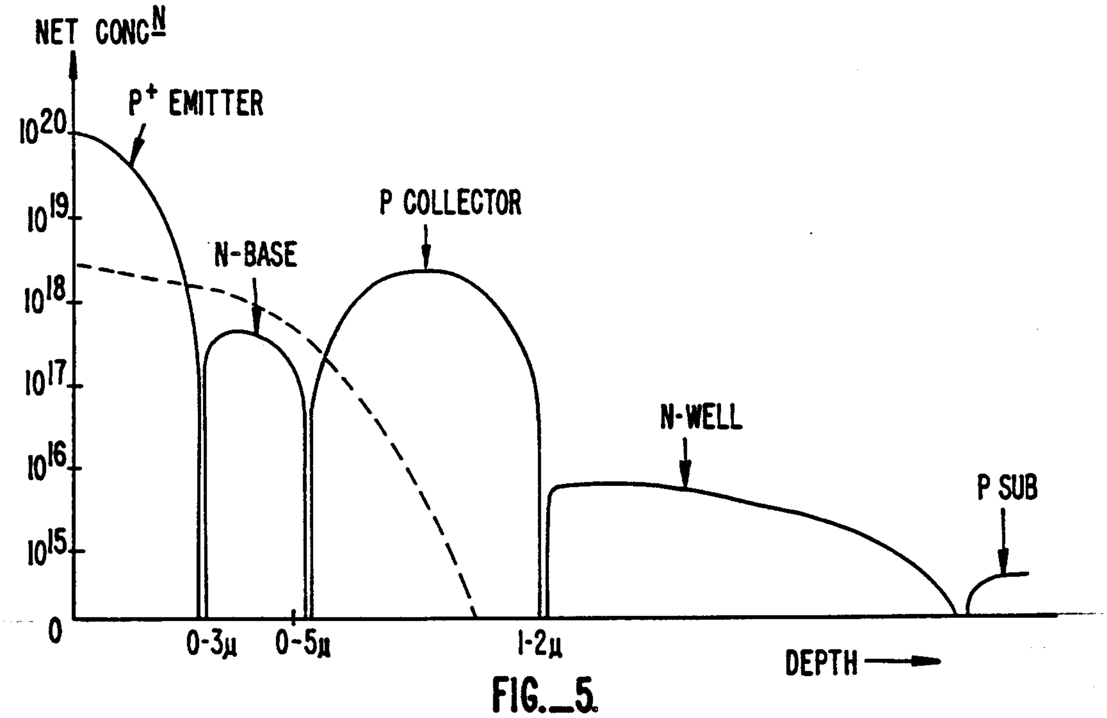
NET CONC$^{N}$
P$^{+}$ EMITTER
P COLLECTOR
N-BASE
N-WELL
P SUB
$10^{20}$
$10^{19}$
$10^{18}$
$10^{17}$
$10^{16}$
$10^{15}$
0
0-3μ
0-5μ
1-2μ
DEPTH

FIG._5.

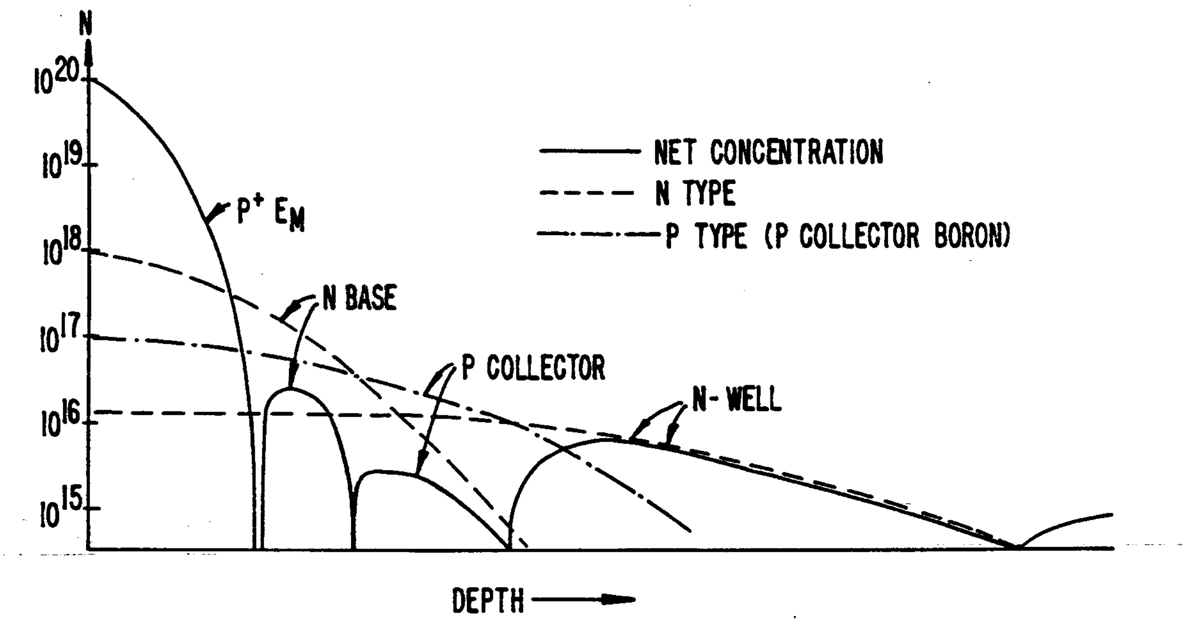
N
$10^{20}$
$10^{19}$
$10^{18}$
$10^{17}$
$10^{16}$
$10^{15}$
NET CONCENTRATION
N TYPE
P TYPE (P COLLECTOR BORON)
P$^{+}$ E$_{M}$
N BASE
P COLLECTOR
N- WELL
DEPTH

FIG._6.

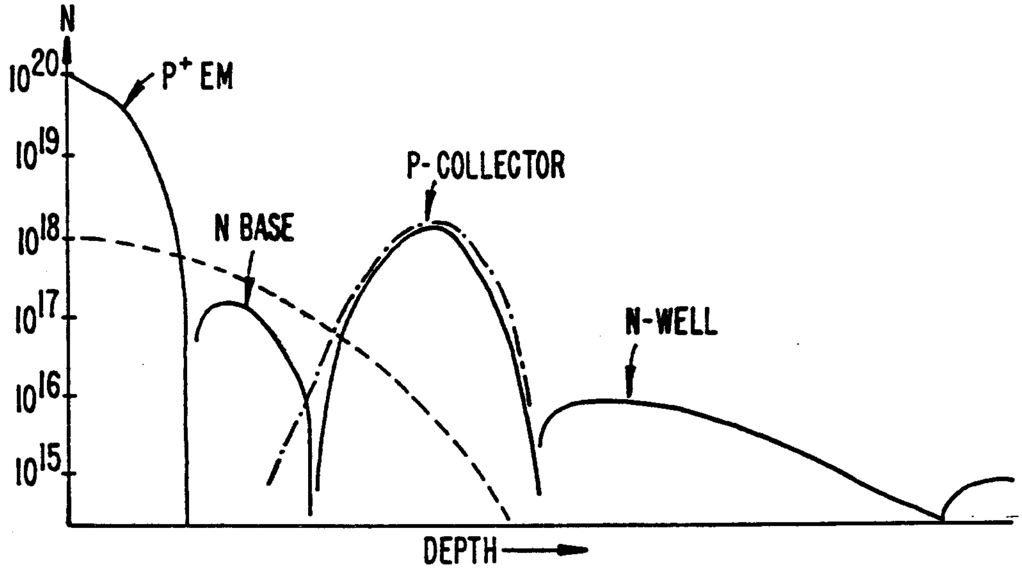


FIG._7.

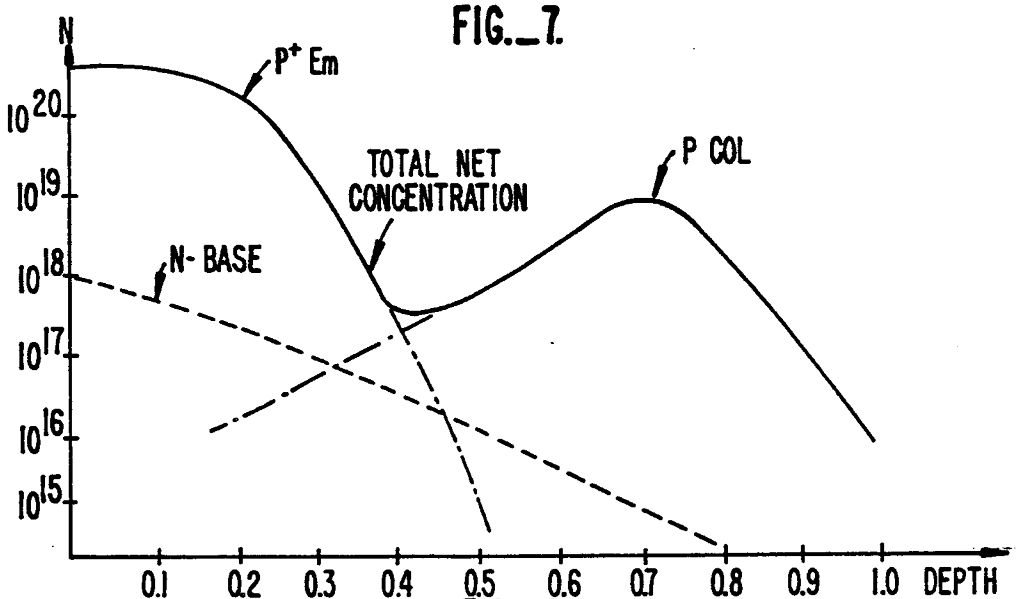


FIG._8.

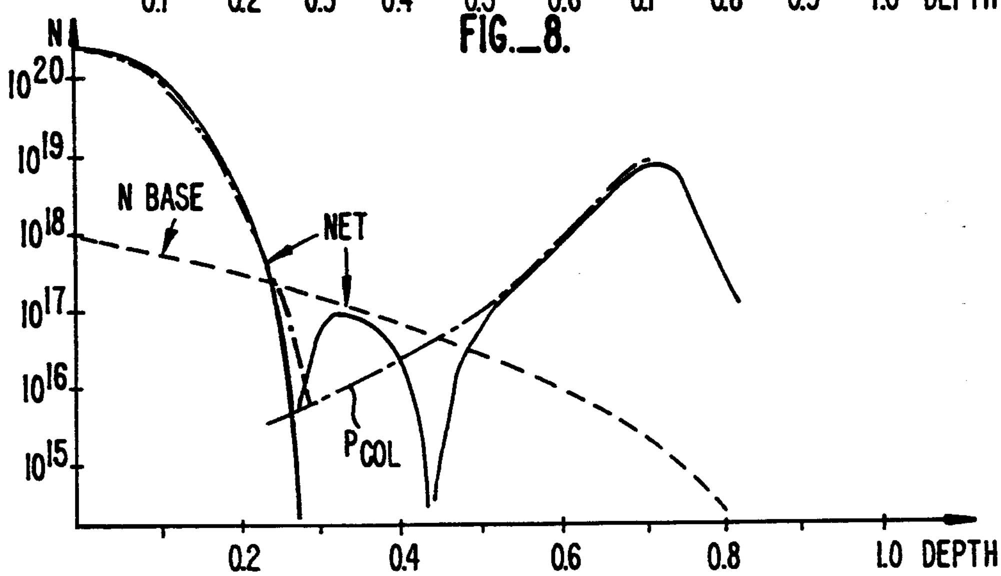


FIG._9.

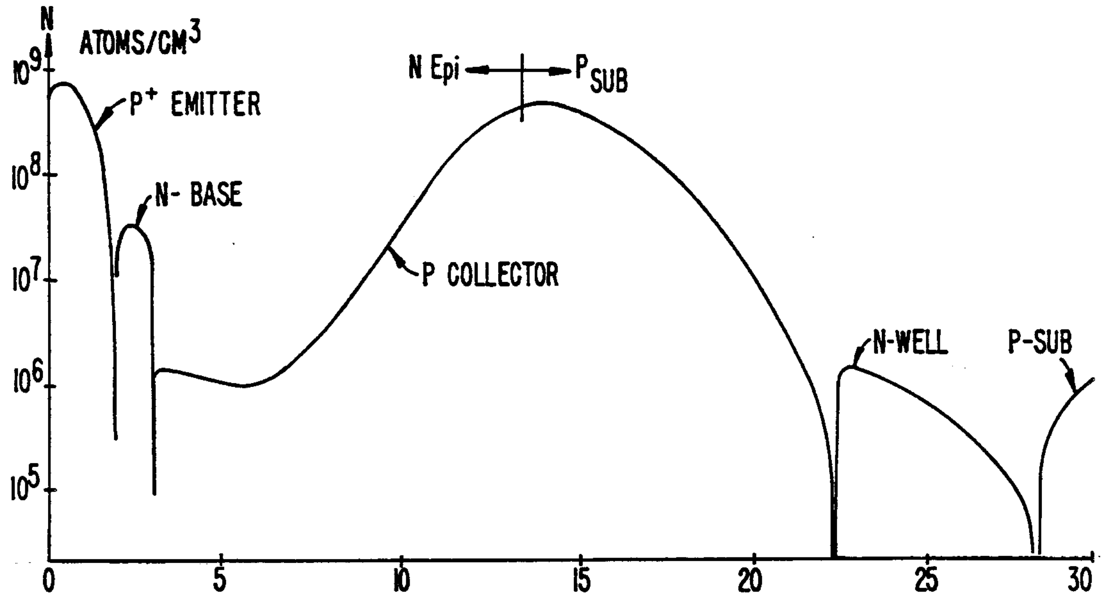


FIG._10A. PRIOR ART

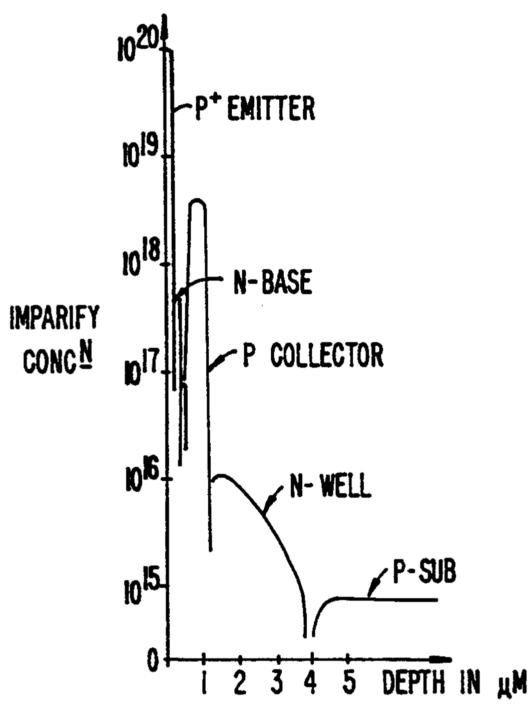


FIG._10B.

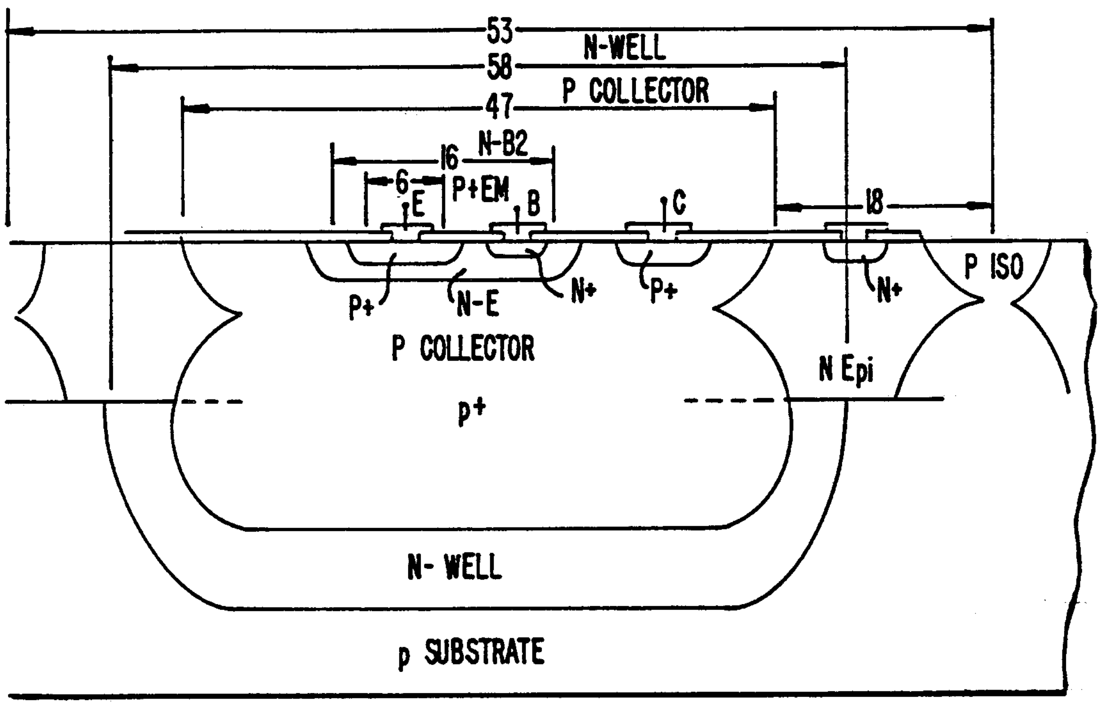


FIG._11A. PRIOR ART

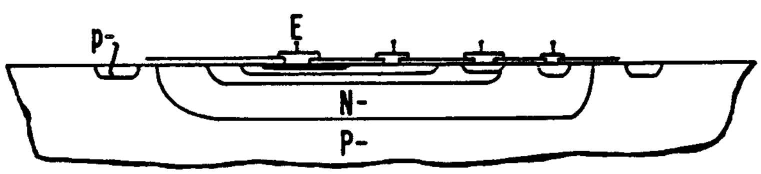


FIG._11B.